# EUROPÄISCHE PATENTSCHRIFT

(11) **EP 3 891 023 B1**
(45) Veröffentlichungstag und Bekanntmachung des Hinweises auf die Patenterteilung: **12.10.2022**
(21) Anmeldenummer: 20706185.4
(22) Anmeldetag: 17.02.2020
(51) Int. Cl.: B60R 21/203, B60Q 5/00, B62D 1/04

(54) **FAHRZEUGLENKRAD MIT VERBESSERTER ELEKTROMECHANISCHER AUSLÖSEEINRICHTUNG, UM EINE AKUSTISCHE AUSGABE DURCH EINE AKUSTISCHE WARNEINRICHTUNG DES FAHRZEUGS AUSZULÖSEN**
VEHICLE STEERING WHEEL WITH AN IMPROVED ELECTROMECHANICAL TRIGGERING DEVICE FOR TRIGGERING AN ACOUSTIC OUTPUT BY AN ACOUSTIC WARNING DEVICE OF THE VEHICLE
VOLANT DE VÉHICULE AVEC DISPOSITIF DE DÉCLENCHEMENT ÉLECTROMÉCANIQUE AMÉLIORÉ POUR DÉCLENCHER UNE ÉMISSION ACOUSTIQUE AU MOYEN D'UN DISPOSITIF D'AVERTISSEMENT ACOUSTIQUE DU VÉHICULE

(30) Priorität: 01.04.2019 DE 102019108460; 09.10.2019 DE 102019127120
(43) Veröffentlichungstag der Anmeldung: 13.10.2021
(73) Patentinhaber: Preh GmbH, 97616 Bad Neustadt a.d. Saale (DE)
(72) Erfinder: KATZENBERGER, Oliver, 97724 Burglauer (DE); SCHRENK, Sebastian, 97656 Oberelsbach-Ginolfs (DE); WAHL, Stefan, 97616 Bad Neustadt a.d. Saale (DE); SCHÄFER, Martin, 97618 Hohenroth (DE); RUETZEL, Dirk, 36157 Ebersburg (DE)
(74) Vertreter: Lohmanns, Bernard
(86) Internationale Anmeldenummer: PCT/EP2020/054063
(87) Internationale Veröffentlichungsnummer: WO 2020/200571

(56) Entgegenhaltungen:
- EP-A2- 1 623 886
- DE-U1- 29 805 207
- GB-A- 2 309 123
- US-A1- 2005 012 310

## Beschreibung

Die Erfindung betrifft ein Fahrzeuglenkrad mit verbesserter elektromechanischer Auslöseeinrichtung zur Auslösung einer akustischen Ausgabe durch eine akustische Warneinrichtung des Fahrzeugs, also beispielsweise zur Ausgabe eines akustischen Hupsignals durch eine Hupe des Kraftfahrzeugs. Ein Fahrzeuglenkrad weist typischerweise einen Nabenbereich (auch kurz Nabe genannt) zur Befestigung an einer Lenkwelle, einen Lenkradkranz sowie wenigstens eine Speiche zur Abstützung des Lenkradkranzes an dem Nabenbereich auf.

Typischerweise bildet dabei die die Nabe des Lenkrads bedeckende Pralltopfabdeckung die Bedienoberfläche für einen elektromechanischen Taster aus, indem die Pralltopfabdeckung zur Auslösung der Hupe niedergedrückt wird. Die Auslösung sollte nur bei zielgerichteter intendierter Betätigung und nicht bei zufälliger Berührung ausgelöst werden. Da gleichzeitig die Pralltopfabdeckung die Abdeckung für eine im Bereich der Nabe des Lenkrads angeordnete Airbag-Zündeinrichtung ausbildet, ist der Konstrukteur vor einige Schwierigkeiten gestellt, den Taster zur Auslösung des Hupsignals geschickt zu platzieren. Die Airbag-Zündeinrichtung besteht im Allgemeinen aus einem Gassack, der ein Volumen von ca. 67 l hat, einem Gassackhalter, einem Generator und einem Generatorträger. Typischerweise ist die Pralltopfabdeckung an der Airbag-Zündeinrichtung befestigt und der vorgenannte Taster zwischen dem Lenkradkörper und der Airbag-Zündeinrichtung angeordnet. Dies hat nicht nur mechanische Nachteile bezüglich des Kraftverlaufs bei der Übertragung der Betätigungskraft bei der Auslösung des sogenannten Hupsignals, sondern es hat auch Nachteile bei der optischen und mechanischen Auslegung der Lenkradoberflächengestaltung. Dadurch dass bei den bekannten Lösungen die Pralltopfabdeckung zusammen mit der Airbag-Zündeinrichtung beweglich am Lenkradkörper zu lagern ist, ist eine aus optischen und verletzungstechnischen Gründen angestrebter nahezu spaltfreier Übergang zwischen der Betätigungsoberfläche der Pralltopfabdeckung und der Oberfläche des Lenkradkörpers insbesondere im Bereich der Speiche nicht zu realisieren.

US2005/012310 A1 offenbart ein Fahrzeuglenkrad nach dem Oberbegriff von Anspruch 1.

Der Erfindung liegt daher die Aufgabe zugrunde, ein Fahrzeuglenkrad, auch kurz als Lenkrad bezeichnet, mit verbesserter mechanischer und optischer Integration einer elektromechanischen Auslöseeinrichtung zur Auslösung einer akustischen Ausgabe durch eine akustische Warneinrichtung des Fahrzeugs bereitzustellen, die insbesondere hinsichtlich der Detektion der Betätigungskraft verbessert ist und bauraumsparend realisiert ist. Erfindungsgemäß wird die Aufgabe durch ein Fahrzeuglenkrad mit den Merkmalen des Anspruchs 1 gelöst. Eine gleichermaßen vorteilhafte Verwendung ist Gegenstand des nebengeordneten Anspruchs. Es ist darauf hinzuweisen, dass die in der nachfolgenden Beschreibung einzeln aufgeführten Merkmale sowie Maßnahmen in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Das erfindungsgemäße Fahrzeuglenkrad weist einen Lenkradkörper mit einem Nabenbereich, der zur Befestigung an einer Lenkwelle ausgebildet ist, einen Lenkradkranz sowie wenigstens eine Speiche zur Befestigung des Lenkradkranzes an dem Nabenbereich auf. Der Lenkradkranz bildet die Grifffläche des Lenkrades aus und ist üblicherweise als ein geschlossener Ring ausgebildet und dient der Lenkverstellung eines Lenkungssystems durch Verdrehen des Fahrzeuglenkrades um seine Drehachse. Der Lenkradkranz muss nicht zwingend geschlossen sein, so ist auch eine erfindungsgemäße Ausführungsform denkbar, bei der der Lenkradkranz lediglich einen Teil eines Ringes ausbildet. Beispielsweise bildet der Lenkradkranz ein sogenanntes mit einer einzigen Speiche verbundenes Lenkradhorn als Grifffläche aus oder ist bildet einen Halb- bis Dreivierteilkreis, wobei er mit einer, zwei oder mehr Speichen verbunden ist.

Das erfindungsgemäße Fahrzeuglenkrad weist ferner eine Airbag-Zündeinrichtung auf. Diese umfasst beispielsweise einen Gassack (auch "Luftsack" genannt), einen Gassackhalter, einen Generator zur Erzeugung eines den Gassack füllenden Gases sowie einen Generatorträger.

Erfindungsgemäß ist ferner eine elektromechanische Auslöseeinrichtung vorgesehen, um eine akustische Ausgabe durch eine akustische Warneinrichtung des Fahrzeugs auszulösen. Die erfindungsgemäß vorgesehene Auslöseeinrichtung weist eine am Lenkradkörper den Nabenbereich zumindest teilweise bedeckende und dabei eine Betätigungsoberfläche ausbildende Pralltopfabdeckung (auch kurz "Kappe" genannt) auf. Die Pralltopfabdeckung ist ausgebildet, dass sie einen zwischen dem Nabenbereich und der Pralltopfabdeckung vorgesehenen und zur wenigstens teilweisen Aufnahme der Airbag-Zündeinrichtung vorgesehenen Aufnahmeraum überbrückt, bevorzugt freitragend, d.h. ohne mittlere Abstützung zwischen den äußeren Abstützungen am Lenkradkörper, überbrückt. Beispielsweise ist die Airbag-Zündeinrichtung am Lenkradkörper festgelegt. Die Pralltopfabdeckung ist unter Einwirkung einer Betätigungskraft auf die Betätigungsoberfläche in Richtung Nabenbereich elastisch rückstellend am Lenkradkörper verlagerbar gelagert und/oder elastisch rückstellend in Richtung Nabenbereich verformbar ausgebildet. Als Verlagerung wird bereits eine Lageänderung von einem Bruchteil, wie ein Zehntel, eines Millimeters verstanden. Sie weist erfindungsgemäß wenigstens eine über den Aufnahmeraum hinaus, seitlich in Richtung Lenkradkranz überstehende Auskragung auf. Beispielsweise sind zwei diametral gegenüberliegende, voneinander wegweisende und sich dabei jeweils entlang einer Speiche des Lenkradkörpers erstreckende Auskragungen vorgesehen.

Erfindungsgemäß weist die elektromechanische Auslöseeinrichtung ferner wenigstens einen, bevorzugt drei oder mehr, zwischen der Auskragung und dem Lenkradkörper angeordneten Kraftaufnehmer auf, über den die Pralltopfabdeckung am Lenkradkörper abgestützt ist, um einen Kraftwert zu messen, der einer auf die Betätigungsoberfläche der Pralltopfabdeckung einwirkenden Betätigungskraft zugeordnet werden kann.

Erfindungsgemäß weist die elektromechanische Auslöseeinrichtung ferner wenigstens eine elektrisch leitend mit dem oder den Kraftaufnehmern verbundene Auswertelektronik auf, um mittels des von dem wenigstens einen Kraftaufnehmer gemessenen Kraftwerts einen Betätigungskraftwert zu ermitteln und gegebenenfalls die akustische Ausgabe der akustischen Warneinrichtung des Fahrzeugs auszulösen. Beispielsweise erfolgt die Auslösung, wenn der Betätigungskraftwert einen vorgegebenen Schwellwert überschreitet. Bei mehreren Kraftaufnehmern wird der Betätigungskraftwert durch Mittelung aller Kraftwerte, gegebenenfalls gewichtete Mittelung aller Kraftwerte ermittelt. Die Wichtung ergibt sich dabei aus der Neigung der Lenkwelle bzw. der Lenksäule und/oder dem Lenkwinkel, die jeweils durch entsprechend platzierte Sensoren detektierbar sind. Bei mehreren Kraftaufnehmern wird die Überschreitung eines Schwellwertes durch eine zentrale Auswerteinheit oder durch eine übergeordnete Auswerteinheit ermittelt

Dadurch, dass der oder die Kraftaufnehmer zwischen der Pralltopfabdeckung und dem Lenkradkörper angeordnet ist beziehungsweise sind, wird ein vergleichsweise kurzer und nur über eine Komponente erfolgender Kraftverlauf zwischen Betätigungsoberfläche und Kraftaufnehmer erreicht. Das schafft eine genaue Betätigungskraftermittlung.

Bevorzugt ist der wenigstens eine Kraftaufnehmer außerhalb der durch das Fahrzeuglenkrad definierten Lenkachse angeordnet und noch bevorzugter außerhalb des für die Aufnahme der Airbag-Zündeinrichtung vorgesehenen Aufnahmeraums, meist bevorzugt radial neben der Airbag-Zündeinrichtung angeordnet.

Bevorzugt ist vorgesehen, dass die Betätigungsoberfläche sich über den Aufnahmeraum, bevorzugt unter Ausbildung eines stetigen Übergangs, in die Auskragung erstreckt. Anders ausgedrückt, der oder die Auskragungen und der über dem Aufnahmebereich angeordnete Bereich des Pralltopfabdeckung bilden die Betätigungsoberfläche aus.

Bevorzugt sind wenigstens zwei, beispielsweise drei, Kraftaufnehmer vorgesehen.

Bevorzugt weist die Auswertelektronik eine zentrale Auswerteinheit auf, um aus Kraftwerten mehrerer, bevorzugt aller, Kraftaufnehmer eine Betätigungskraft zu ermitteln. Alternativ kann ein Master/Slave-System zur Anwendung kommen, bei der eine einem Kraftaufnehmer zugeordnete Auswerteinheit als übergeordneter Master vorgesehen. Beispielsweise ist zur Datenkommunikation zwischen den Kraftaufnehmern ein Bussystem vorgesehen.

Bevorzugt ist der Kraftaufnehmer jeweils zwischen der Speiche des Lenkradkörpers und eine der Auskragungen angeordnet.

Bevorzugt ist der Kraftaufnehmer ausgelegt, den Kraftwert optisch, kapazitiv, induktiv oder resistiv zu messen. Bevorzugt wird ein optisch messender Kraftaufnehmer verwendet. Beispielsweise wird ein optisches Reflexionsmessverfahren verwendet, bei dem die Lichtintensität oder die Laufzeit des Lichtes mit der zu messenden Kraft variiert. Bevorzugt sind Mitte! vorgesehen, um den oder die Kraftaufnehmer vorzuspannen, wodurch lenkradstellungsabhängige Schwerkrafteinwirkungen auf die Pralltopfabdeckung minimiert werden können.

Bevorzugt ist als ein Rückstellelement, welches die elastische Rückstellung der Pralltopfabdeckung bewirkt, ein Dom aus elastischem Material, wie einem Elastomer, Kautschuk etc., vorgesehen. Als Dom wird beispielsweise ein Hohlkegel verstanden.

Bevorzugt ist der Kraftaufnehmer in einem von dem Dom definierten Hohlvolumen angeordnet. Beispielsweise weist der Dom ein zu einer Seite offenes Hohlvolumen auf und der Dom ist über den Kraftaufnehmer gestülpt. Beispielsweise wird Licht vom offenen Ende des Doms in das geschlossene Ende des Doms abgestrahlt, um dort wieder in Richtung des offenen Endes reflektiert zu werden, wo es letztlich wieder empfangen zu werden. Entsprechend sind die Lichtquelle und der Empfänger gemeinsam auf einer sich unter dem Dom erstreckenden, das Hohlvolumen begrenzenden Leiterplatte angeordnet.

Gemäß einer Ausgestaltung sind mehrere Speichen vorgesehen und mehrere Auskragungen an der Pralltopfabdeckung vorgesehen, wobei sich die Pralltopfabdeckung von Speiche zu Speiche erstreckt, wobei sie den Nabenbereich überbrückt.

Erfindungsgemäß ist ein elektronisches oder elektromechanisches, im Bereich einer der Speichen angeordnetes Bedienelement, insbesondere ein multifunktionales Bedienelement (auch kurz "Mufu" genannt), vorgesehen und die Pralltopfabdeckung ist an das Bedienelement angrenzend angeordnet. Als multifunktionelles Bedienelement wird ein Bedienelement mit mehr als zwei Steuer- bzw. Schaltfunktionen verstanden. Bevorzugt ist die Pralltopfabdeckung an dem Bedienelement in wenigstens einer Richtung festgelegt. Beispielsweise sind an zwei gegenüberliegenden Speichen jeweils ein Bedienelement angeordnet. Beispielsweise weist das Bedienelement einen Fingerabdrucksensor mit einer Scanoberfläche zur Erfassung biometrischer Daten und/oder zur Cursorsteuerung mittels Erfassung eines sich über die Scanoberfläche bewegenden Fingerabdrucks auf.

In einer Ausgestaltung ist ein Positioniereingriff zwischen Pralltopfabdeckung und Bedienelement vorgesehen, um eine vorgegebene relative Ausrichtung zwischen Bedienelement und Pralltopfabdeckung zu gewährleisten. Beispielsweise ist ein Zapfen vorgesehen, der in eine Ausnehmung des Bedienelements eingreift.

Bevorzugt ist die Pralltopfabdeckung über eine Schnappverbindung, die ferner die Beweglichkeit der Pralltopfabdeckung beanschlagend ausgebildet ist, am Bedienelement festgelegt. Beispielsweise ist eine Rastnase am Bedienelement ausgebildet, die in eine Rastausnehmung eines Rastvorsprungs eingreift, die an der Pralltopfabdeckung ausgebildet ist. Beispielsweise ist die Schnappverbindung so ausgebildet, dass das Rückstellelement in der Ruhestellung der Pralltopfabdeckung vorgespannt ist.

Erfindungsgemäß ist der Kraftaufnehmer auf einer Leiterplatte des Bedienelements befestigt. Beispielsweise sind die Lichtquelle und der Empfänger des zuvor beschriebenen optisch detektierenden Kraftaufnehmers auf der Leiterplatte des Bedienelements angeordnet und der Dom als Rückstellelement, der in seinem Hohlvolumen Lichtquelle und Empfänger aufnimmt, stützt sich mit seinem offenen Ende auf der Leiterplatte ab.

Bevorzugt weist das Bedienelement ein Betätigungsteil und/oder eine Blende auf, deren dem Fahrer zugewandte Oberfläche in der Ruhestellung des Betätigungsteils und der Pralltopfabdeckung bündig in die Betätigungsoberfläche der Pralltopfabdeckung übergeht.

Die Erfindung betrifft ferner die Verwendung des Fahrzeuglenkrads in einer der zuvor beschriebenen Ausführungsformen in einem Kraftfahrzeug.

Die Erfindung sowie das technische Umfeld werden nachfolgend anhand der Figuren näher erläutert. Es ist darauf hinzuweisen, dass die Figuren eine besonders bevorzugte Ausführungsvariante der Erfindung zeigen, die Erfindung jedoch nicht darauf beschränkt ist. Es zeigen:
- Fig. 1: eine Aufsicht einer Ausführungsform des erfindungsgemäßen Fahrzeuglenkrades 1;
- Fig. 2: eine Teilexplosionsansicht der in Figur 1 gezeigten Ausführungsform des erfindungsgemäßen Fahrzeuglenkrades 1;
- Fig. 3a: eine Ansicht mit Lage der Schnittlinie A'-A' zur Erklärung der Schnittansicht der Fig. 3b;
- Fig. 3b: eine Schnittansicht des erfindungsgemäßen Fahrzeuglenkrades 1 aus Figur 1 und 2;
- Fig. 4: eine Detailansicht der Ausführungsform des erfindungsgemäßen Fahrzeuglenkrades 1 aus Figur 1 und 2;
- Fig. 5: eine Detailschnittansicht der Ausführungsform des erfindungsgemäßen Fahrzeuglenkrades 1 aus Figur 1 und 2;
- Fig. 6: eine Detailschnittansicht der Ausführungsform des erfindungsgemäßen Fahrzeuglenkrades 1 aus Figur 1 und 2;
- Fig. 7: eine schematische Ansicht zur Erläuterung des Kraftaufnehmers 8 der Ausführungsform des erfindungsgemäßen Fahrzeuglenkrades 1 aus Figur 1 und 2;
- Fig. 8: eine weitere schematische Ansicht zur Erläuterung des Kraftaufnehmers 8 der Ausführungsform des erfindungsgemäßen Fahrzeuglenkrades 1 aus Figur 1 und 2.

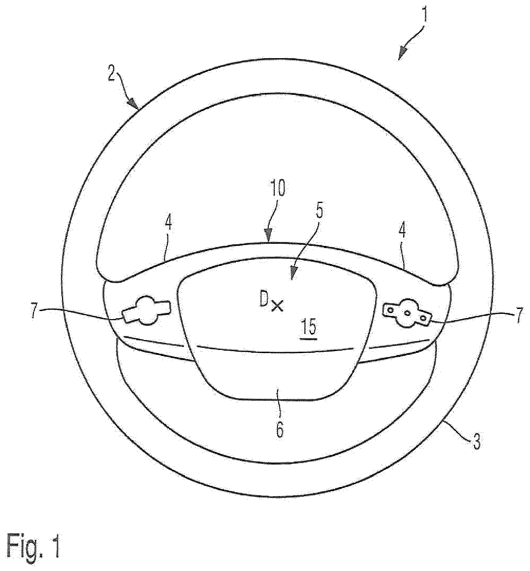

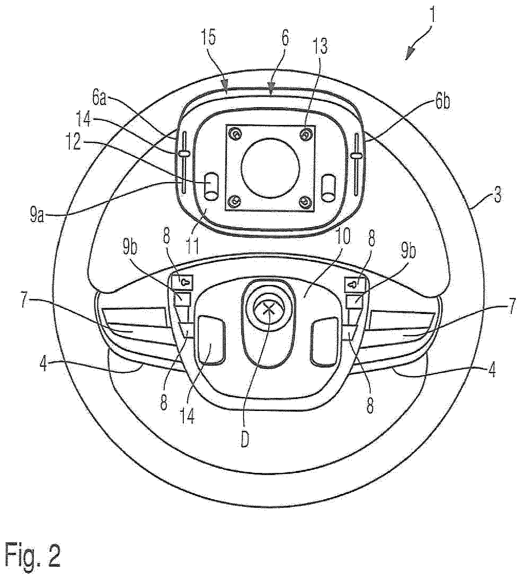

Figur 1 zeigt eine Ausführungsform des erfindungsgemäßen Fahrzeuglenkrads 1 in Aufsicht. Dieses weist einen Lenkradkörper 2 auf. Im Zentrum des Lenkradkörpers 2 weist dieser einen Nabenbereich 10 zur Befestigung an einer nicht dargestellten Lenkwelle einer Fahrzeuglenkung auf. Entsprechend dient das Lenkrad der Vornahme einer Lenkverstellung durch Verdrehen um eine Lenkachse D. Der Nabenbereich 10 ist in Figur 1 unterhalb der dem Fahrer zugewandten Pralltopfabdeckung 6 angeordnet, die zur elektromechanische Auslöseeinrichtung 5 gehört, die wiederum vorgesehen ist, eine akustischen Ausgabe durch eine nicht dargestellte akustische Warneinrichtung des Fahrzeugs, d.h. Hupeinrichtung, auszulösen. Der Lenkradkörper 2 bildet einen den Nabenbereich 10 umlaufenden, ringförmigen Lenkradkranz 3 aus, der durch zwei diametral gegenüberliegende, sich jeweils zwischen dem Nabenbereich 10 und dem Lenkradkranz 3 erstreckende Speichen 4 an dem Nabenbereich 10 abgestützt ist. An den Speichen 4 ist dem Fahrer zugewandt, jeweils ein multifunktionales Bedienelement 7 vorgesehen, das der händischen Bedieneingabe zur Steuerung von Fahrzeugaggregaten dient. Im Zentrum des Lenkradkörpers 2 oberhalb des Nabenbereichs 10 befindet sich unter der Pralltopfabdeckung 6 eine in Figur 1 nicht dargestellte Airbag-Zündeinrichtung. Die Pralltopfabdeckung 6 stellt eine Betätigungsoberfläche 15 bereit, deren händische Betätigung mit einer vorgegebenen Betätigungskraft zur Auslösung der akustischen Ausgabe führt, wie nachfolgend erläutert wird. Figur 2 ist eine Explosionsdarstellung, bei der die Pralltopfabdeckung 6 samt Airbag-Zündeinrichtung abgenommen ist und der Blick einerseits auf den unter der Airbag-Zündeinrichtung befindlichen Generatorträger 11, der von der Pralltopfabdeckung 6 freitragend überdeckt ist und andererseits auf den Nabenbereich 10 des Lenkradkörpers 2 freigegeben ist.

Der Generatorträger 11 ist zur Schwingungsentkopplung mittels vier Schwingungstilger 13 aus Gummi am Nabenbereich 10 gelagert, wobei die zwei am Generatorträger 11 vorgesehenen Rastzapfen 12, die in Rasteingriff mit den am Nabenbereich 10 vorgesehenen Rastfedern 14 stehen, eine Festlegung am Nabenbereich 10 bewirken. Die Pralltopfabdeckung 6 weist seitliche, sich entlang der Speichen 4 in Richtung Lenkradkranz 3 erstreckende Auskragungen 6a, 6b auf, die auf der dem Fahrer abgewandten Seite eine Positionierhilfe 14 und einen Rastvorsprung 9b ausbilden. Der Rastvorsprung 9a wirkt mit einer seitens des Bedienelements 7 ausgebildeten Rastnase 9b zusammen, so wird eine spielbehaftete Schnappverbindung 9 zwischen der Pralltopfabdeckung 6 und jeweils einem der multifunktionalen Bedienelemente 7 ausgebildet, um die Beweglichkeit des Pralltopfabdeckung 6 in Richtung der Betätigung so zu beanschlagen, dass die Pralltopfabdeckung 6 trotz dieser Beanschlagung unter Einwirkung einer Betätigungskraft auf die Betätigungsoberfläche 15 in Richtung Nabenbereich 10 elastisch am Lenkradkörper 2 und dabei rückstellend gelagert und beweglich bleibt.

Die dabei anliegende Betätigungskraft wird anhand der Verlagerung der Pralltopfabdeckung 6 mittels der zur elektromechanischen Auslöseeinrichtung 5 gehörigen Kraftaufnehmer 8 ermittelt. Über den Kraftaufnehmer 8 ist die Pralltopfabdeckung 6 am Lenkradkörper 2 abgestützt, um einen Kraftwert zu messen, der einer auf die Betätigungsoberfläche 15 der Pralltopfabdeckung 6 einwirkenden Betätigungskraft zugeordnet werden kann. Die Kraftaufnehmer 8 sind außerhalb der durch das Fahrzeuglenkrad 1 definierten Lenkachse D angeordnet und außerhalb eines für die Aufnahme der Airbag-Zündeinrichtung 17, 18 vorgesehenen Aufnahmeraums und radial neben der Airbag-Zündeinrichtung 17, 18 angeordnet ist.

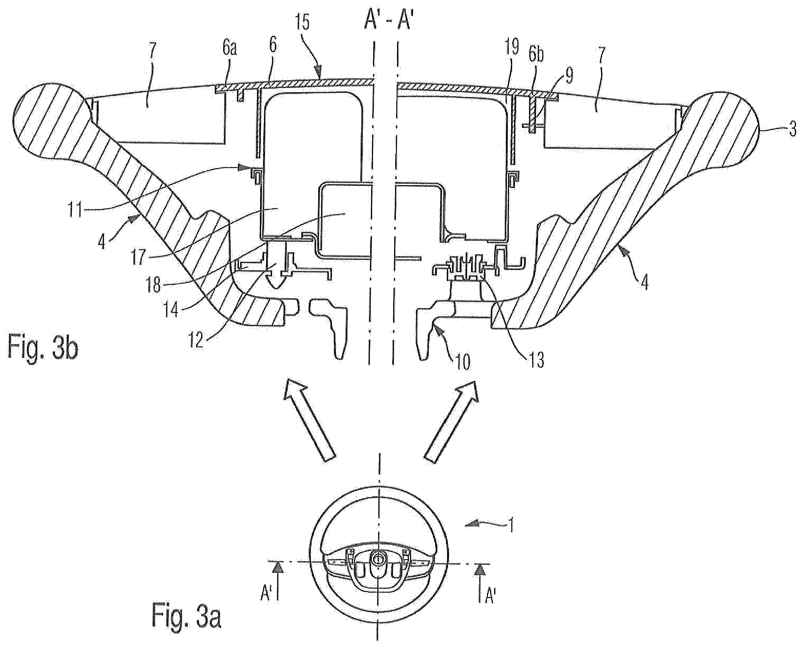

In der Schnittdarstellung der Figuren 3a und 3b ist ferner gezeigt, dass sich die Pralltopfabdeckung 6 freitragend über den Nabenbereich 10 erstreckt und dabei den Aufnahmeraum 19 überbrückt, der zur wenigstens teilweisen Aufnahme der Airbag-Zündeinrichtung 17, 18 aus dem Gasgenerator 18 und dem Gassack 17 vorgesehenen Aufnahmeraum 19 überbrückend ausgebildet ist. Wie ferner daraus ersichtlich, ist die Pralltopfabdeckung 6 derart ausgebildet, dass die Betätigungsoberfläche 15 sich über den Aufnahmeraum 19, unter Ausbildung eines stetigen Übergangs in die Auskragungen 6a, 6b erstreckt.

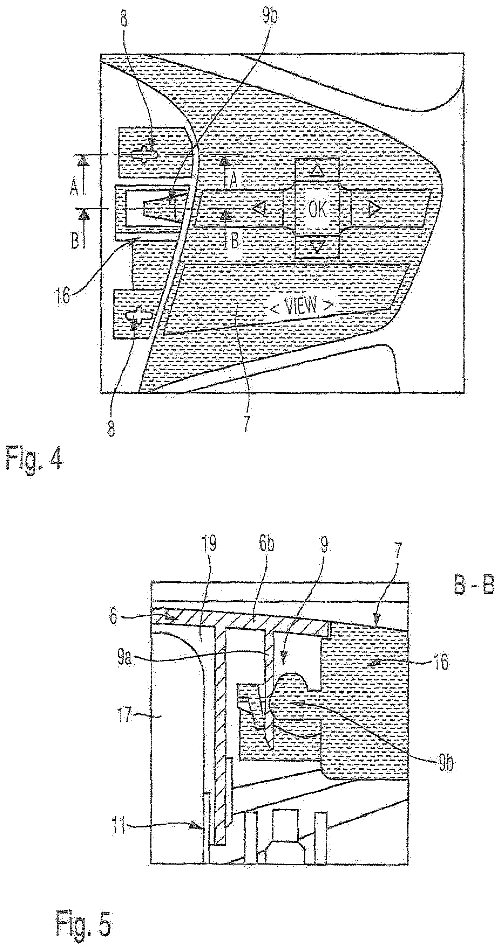

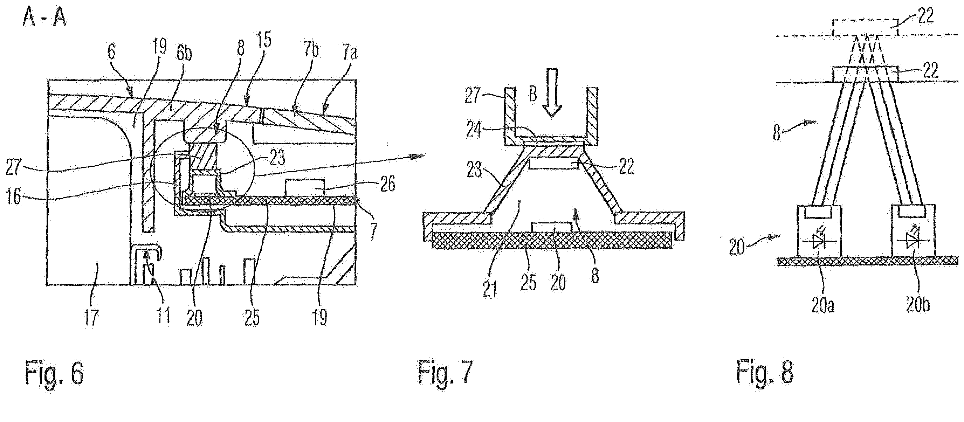

Figur 4 ist eine Detailaufsicht auf das multifunktionale Bedienelement 7 bei abgenommener Pralltopfabdeckung 6. Es ist die die Schnappverbindung 9 zwischen der Pralltopfabdeckung 6 und dem Bedienelement 7 herstellende Rastnase 9b gezeigt, deren Funktion in der Figur 5, die den Schnitt entlang der Schnittline B-B aus Figur 4 wiedergibt, zu erkennen ist. Die Rastnase 9b wirkt mit dem von der Auskragung 6b vorstehenden Rastvorsprung 9a zusammen, indem sie so in dessen Rastausnehmung eingreift, dass sich die die Beweglichkeit der Pralltopfabdeckung 6 beanschlagende Schnappverbindung 16 ausbildet. Die Figur 6 entspricht dem Schnitt entlang der Schnittlinie A-A aus Figur 4 und zeigt im Wesentlichen die Funktion der optischen Kraftaufnehmer 8 sowie der die elastische Rückstellung der Pralltopfabdeckung 6 bewirkenden Rückstellelemente 23. Eine vergrößerte Detailansicht ergibt sich aus Figur 7. Die Rückstellelemente 23 sind jeweils aus einem Elastomer und domförmig ausgebildet und jeweils unter einer der Auskragungen 6a, 6b angeordnet, um jeweils die Rückstellung der Pralltopfabdeckung 6 aus einer betätigten Stellung in eine unbetätigte Stellung zu bewirken.

Wie aus Figur 6 ersichtlich, weist das Bedienelement 7 jeweils ein Betätigungsteil 7b auf, dessen dem Fahrer zugewandte Oberfläche 7a in einer Ruhestellung des Betätigungsteils 7b und in einer Ruhestellung, d.h. unbetätigten Stellung der Pralltopfabdeckung 6 bündig in die Betätigungsoberfläche 15 der Pralltopfabdeckung 6 übergeht.

Das Rückstellelement 23 stützt sich einerseits auf einer zum multifunktionalen Bedienelement 7 gehörigen Leiterplatte 25 und andererseits über einen im Gehäuse 16 des multifunktionalen Bedienelements 7 geführten Stößel 27 an der rückwärtigen, d.h. dem Fahrer abgewandten Seite der Auskragung 6b der Pralltopfabdeckung 6 ab. Das durch das Rückstellelement 23 und die Leiterplatte 25 ausgebildete Hohlvolumen 21 wird zur Anordnung des optischen Kraftaufnehmers 8 genutzt, der elektrisch leitend mit einer Auswertelektronik 26 verbunden ist, die auf der Leiterplatte 25 des multifunktionalen Bedienelements 7 angeordnet ist. Die Auswertelektronik 26 ist ausgebildet, mittels der von den Kraftaufnehmern 8 gemessenen Kraftwerte einen Betätigungskraftwert zu ermitteln und bei Überschreiten eines vorgegebenen Wertes die akustische Ausgabe der akustischen Warneinrichtung des Fahrzeugs auszulösen.

Die Funktion des optischen Kraftaufnehmers 8 wird durch die Figuren 7 und 8 deutlich. Der Kraftaufnehmer 8 weist eine Kombination 20 aus einem optischen Sender 20a und optischem Empfänger 20b. Das von dem Sender 20a abgestrahlte Licht wird an einem Reflektor 22 in Richtung des Empfängers 20b reflektiert. Der Reflektor 22 ist auf der dem Stößel 27 abgewandten Seite des Rückstellelements 23 im Hohlvolumen 21 angeordnet. Die von dem Reflektor 22 auf den Empfänger 20b reflektierte Lichtmenge variiert eindeutig mit der durch die Betätigung bewirkten Verformung des Rückstellelements 23 und ist damit ein Maß für den durch den Kraftaufnehmer zu messenden Kraftwert.

## Patentansprüche

1. Fahrzeuglenkrad (1), aufweisend
einen Lenkradkörper (2) mit einem Nabenbereich (10) zur Befestigung an einer Lenkwelle, mit einem Lenkradkranz (3) sowie wenigstens einer Speiche (4) zur Befestigung des Lenkradkranzes (3) an dem Nabenbereich (10);
eine Airbag-Zündeinrichtung (17, 18);
eine elektromechanische Auslöseeinrichtung (5), um eine akustischen Ausgabe durch eine akustische Warneinrichtung des Fahrzeugs auszulösen, wobei die Auslöseeinrichtung (5) eine am Lenkradkörper (2) den Nabenbereich (10) zumindest teilweise bedeckende und dabei eine Betätigungsoberfläche (15) ausbildende Pralltopfabdeckung (6) aufweist, wobei die Pralltopfabdeckung (6) einen zwischen dem Nabenbereich (10) und der Pralltopfabdeckung (6) vorgesehenen und zur wenigstens teilweisen Aufnahme der Airbag-Zündeinrichtung (17, 18) vorgesehenen Aufnahmeraum (19) überbrückend ausgebildet ist und die Pralltopfabdeckung (6) unter Einwirkung einer Betätigungskraft auf die Betätigungsoberfläche (15) in Richtung Nabenbereich (10) elastisch am Lenkradkörper (2) verlagerbar und dabei rückstellend gelagert ist und/oder elastisch in Richtung Nabenbereich (10) verformbar und dabei rückstellend ausgebildet ist und die Pralltopfabdeckung (6) wenigstens eine über den Aufnahmeraum (19) hinaus, seitlich in Richtung Lenkradkranz (3) überstehende Auskragung (6a, 6b) aufweist;
wobei die elektromechanische Auslöseeinrichtung (5) ferner wenigstens einen zwischen der Auskragung (6a, 6b) und dem Lenkradkörper (2) angeordneten Kraftaufnehmer (8) aufweist, über den die Pralltopfabdeckung (6) am Lenkradkörper (2) abgestützt ist, um einen Kraftwert zu messen, der einer auf die Betätigungsoberfläche (15) der Pralltopfabdeckung (6) einwirkenden Betätigungskraft zugeordnet werden kann;
wobei die elektromechanische Auslöseeinrichtung (5) ferner wenigstens eine elektrisch leitend mit dem Kraftaufnehmer (8) verbundene Auswertelektronik (26) umfasst, um mittels des von dem wenigstens einen Kraftaufnehmer (8) gemessenen Kraftwerts einen Betätigungskraftwert zu ermitteln und gegebenenfalls die akustische Ausgabe der akustischen Warneinrichtung des Fahrzeugs auszulösen, wobei ferner ein elektronisches oder elektromechanisches, im Bereich der Speiche (4) angeordnetes Bedienelement (7), insbesondere ein multifunktionales Bedienelement, vorgesehen ist, und die Pralltopfabdeckung (6) an das Bedienelement (7) angrenzend angeordnet ist, bevorzugt daran festgelegt ist,
**dadurch gekennzeichnet, dass**
der Kraftaufnehmer (8) auf einer Leiterplatte (25) des Bedienelements (7) befestigt ist.

2. Fahrzeuglenkrad (1) nach dem vorhergehenden Anspruch, wobei die Betätigungsoberfläche (15) sich über den Aufnahmeraum (19), bevorzugt unter Ausbildung eines stetigen Übergangs, in die Auskragung (6a, 6b) erstreckt.

3. Fahrzeuglenkrad (1) nach einem der vorhergehenden Ansprüche, wobei wenigstens zwei Auskragungen (6a, 6b) mit jeweils mindestens einem Kraftaufnehmer (8) vorgesehen sind.

4. Fahrzeuglenkrad (1) nach einem der vorhergehenden Ansprüche, wobei die Auswertelektronik (26) eine zentrale Auswerteinheit aufweist, um aus Kraftwerten mehrerer, bevorzugt aller, Kraftaufnehmer (8) eine Betätigungskraft zu ermitteln.

5. Fahrzeuglenkrad (1) nach einem der vorhergehenden Ansprüche, wobei der Kraftaufnehmer (8) jeweils zwischen Speiche (4) und Auskragung (6a, 6b) angeordnet ist.

6. Fahrzeuglenkrad (1) nach einem der vorhergehenden Ansprüche, wobei der wenigstens eine Kraftaufnehmer (8) außerhalb einer durch das Fahrzeuglenkrad (1) definierten Lenkachse (D) angeordnet, noch bevorzugter außerhalb des für die Aufnahme der Airbag-Zündeinrichtung (17, 18) vorgesehenen Aufnahmeraums (19), meist bevorzugt radial neben der Airbag-Zündeinrichtung (17, 18) angeordnet ist.

7. Fahrzeuglenkrad (1) nach einem der vorhergehenden Ansprüche, wobei der Kraftaufnehmer (8) den Kraftwert optisch, kapazitiv, induktiv oder resistiv misst.

8. Fahrzeuglenkrad (1) nach einem der vorhergehenden Ansprüche, wobei Mittel (24) vorgesehen sind, um den Kraftaufnehmer (8) vorzuspannen.

9. Fahrzeuglenkrad (1) nach einem der vorhergehenden Ansprüche, wobei als ein Rückstellelement (23), welches die elastische Rückstellung der Pralltopfabdeckung (6) bewirkt, ein Dom aus elastischem Material vorgesehen ist.

10. Fahrzeuglenkrad (1) nach dem vorhergehenden Anspruch, wobei der Kraftaufnehmer (8) in einem von dem Dom (23) definierten Hohlvolumen (21) angeordnet ist.

11. Fahrzeuglenkrad (1) nach einem der vorhergehenden Ansprüche, wobei mehrere Speichen (4) vorgesehen sind und die Pralltopfabdeckung (6) mehrere, jeweils sich entlang einer der Speichen erstreckende Auskragung (6a, 6b) aufweist, so dass sich die Pralltopfabdeckung (6) von Speiche (4) zu Speiche (4) dabei den Nabenbereich (10) überbrückend erstreckt.

12. Fahrzeuglenkrad (1) nach einem der vorhergehenden Ansprüche, wobei die Pralltopfabdeckung (6) über eine Schnappverbindung (9), die ferner beanschlagend auf die Beweglichkeit der Pralltopfabdeckung (6) wirkt, und/oder einen Positioniereingriff (14) an dem Bedienelement (7) festgelegt ist.

13. Fahrzeuglenkrad (1) nach einem der vorhergehenden Ansprüche, wobei das Bedienelement (7) ein Betätigungsteil (7b) und/oder eine Blende aufweist, deren dem Fahrer zugewandte Oberfläche (7a) in einer Ruhestellung des Betätigungsteils (7b) und einer Ruhestellung der Pralltopfabdeckung (6) bündig in die Betätigungsoberfläche (15) der Pralltopfabdeckung (6) übergeht.

14. Verwendung des Fahrzeuglenkrades (1) nach einem der vorhergehenden Ansprüche in einem Kraftfahrzeug.

## Claims

1. Vehicle steering wheel (1), having
a steering wheel body (2) with a hub region (10) for fastening to a steering shaft, with a steering wheel rim (3) and with at least one spoke (4) for fastening the steering wheel rim (3) to the hub region (10);
an airbag-activating device (17, 18);
an electromechanical tripping device (5) in order to trip an acoustic output by an acoustic warning device of the vehicle, wherein the tripping device (5) has an impact absorber covering (6) on the steering wheel body (2) at least partially covering the hub region (10) and in so doing forming an actuating surface (15), wherein the impact absorber covering (6) is designed so as to bridge a receiving space (19) provided between the hub region (10) and the impact absorber covering (6) and provided for at least partially receiving the airbag-activating device (17, 18), and the impact absorber covering (6) is mounted such that it can be moved elastically on the steering wheel body (2) under the action of an actuating force onto the actuating surface (15) in the direction of the hub region (10) and such that it is reset in this case and/or is designed to be elastically deformable in the direction of the hub region (10) and such that it is reset in this case, and the impact absorber covering (6) has at least one projection (6a, 6b) protruding beyond the receiving region (19), laterally in the direction of the steering wheel rim (3);
wherein the electromechanical tripping device (5) further has at least one force absorber (8) arranged between the projection (6a, 6b) and the steering wheel body (2), the impact absorber covering (6) being supported on the steering wheel body (2) via said force absorber in order to measure a force value which can be assigned to an actuating force acting on the actuating surface (15) of the impact absorber covering (6);
wherein the electromechanical tripping device (5) further comprises at least one evaluation electronics system (26) electrically conductively connected to the force absorber (8) in order to ascertain an actuating force value by means of the force value measured by the at least one force absorber (8) and to trip the acoustic output of the acoustic warning device of the vehicle if necessary, wherein an electronic or electromechanical operator control element (7) arranged in the region of the spoke (4), in particular a multifunctional operator control element, is further provided, and the impact absorber covering (6) is arranged adjoining the operator control element (7), preferably is secured to it,
**characterized in that**
the force absorber (8) is fastened on a printed circuit board (25) of the operator control element (7).

2. Vehicle steering wheel (1) according to the preceding claim, wherein the actuating surface (15) extends over the receiving space (19) into the projection (6a, 6b), preferably so as to form a continuous transition.

3. Vehicle steering wheel (1) according to either of the preceding claims, wherein at least two projections (6a, 6b), each with at least one force transducer (8), are provided.

4. Vehicle steering wheel (1) according to one of the preceding claims, wherein the evaluation electronics system (26) has a central evaluation unit in order to ascertain an actuating force from force values of a plurality of, preferably all of, the force transducers (8).

5. Vehicle steering wheel (1) according to one of the preceding claims, wherein the force transducer (8) is arranged between the spoke (4) and a projection (6a, 6b) in each case.

6. Vehicle steering wheel (1) according to one of the preceding claims, wherein the at least one force transducer (8) is arranged outside a steering axis (D) defined by the vehicle steering wheel (1), further preferably outside the receiving space (19) provided for receiving the airbag-activating device (17, 18), most preferably radially next to the airbag-activating device (17, 18).

7. Vehicle steering wheel (1) according to one of the preceding claims, wherein the force transducer (8) measures the force value optically, capacitively, inductively or resistively,

8. Vehicle steering wheel (1) according to one of the preceding claims, wherein means (24) are provided in order to pretension the force transducer (8).

9. Vehicle steering wheel (1) according to one of the preceding claims, wherein a dome composed of elastic material is provided as a resetting element (23) which elastically resets the impact absorber covering (6).

10. Vehicle steering wheel (1) according to the preceding claim, wherein the force transducer (8) is arranged in a hollow volume (21) defined by the dome (23).

11. Vehicle steering wheel (1) according to one of the preceding claims, wherein a plurality of spokes (4) are provided and the impact absorber covering (6) has a plurality of projections (6a, 6b) each extending along one of the spokes, so that the impact absorber covering (6) extends from spoke (4) to spoke (4) in a manner bridging the hub region (10) in the process.

12. Vehicle steering wheel (1) according to one of the preceding claims, wherein the impact absorber covering (6) is secured to the operator control element (7) by means of a snap-action connection (9), which further has a stopping effect on the mobility of the impact absorber covering (6), and/or a positioning recess (14).

13. Vehicle steering wheel (1) according to one of the preceding claims, wherein the operator control element (7) has an actuating part (7b) and/or a panel, the surface (7a) of which that faces the driver merging flush with the actuating surface (15) of the impact absorber covering (6) in an inoperative position of the actuating part (7b) and an inoperative position of the impact absorber covering (6).

14. Use of the vehicle steering wheel (1) according to one of the preceding claims in a motor vehicle.

## Revendications

1. Volant de véhicule (1), présentant
un corps de volant (2) doté d'une zone de moyeu (10) pour la fixation à un arbre de direction, d'une couronne de volant (3) ainsi que d'au moins un rayon (4) permettant de fixer la couronne de volant (3) à la zone de moyeu (10) ;
un dispositif de déclenchement d'airbag (17, 18) ;
un dispositif de déclenchement électromécanique (5) pour déclencher une émission acoustique par un dispositif d'avertissement acoustique du véhicule, le dispositif de déclenchement (5) présentant un recouvrement de pot antichoc (6) recouvrant au moins partiellement la zone de moyeu (10) sur le corps de volant (2) tout en réalisant une surface d'actionnement (15), dans lequel le recouvrement de pot antichoc (6) est réalisé en chevauchant un espace de réception (19) prévu entre la zone de moyeu (10) et le recouvrement de pot antichoc (6) et prévu pour recevoir au moins partiellement le dispositif de déclenchement d'airbag (17, 18), et le recouvrement de pot antichoc (6) peut sous l'effet d'une force d'actionnement sur la surface d'actionnement (15) être décalé élastiquement sur le corps de volant (2) en direction de la zone de moyeu (10) tout en étant monté avec effet de rappel, et/ou est élastiquement déformable en direction de la zone de moyeu (10) tout en étant réalisé avec effet de rappel, et le recouvrement de pot antichoc (6) présente au moins une saillie (6a, 6b) dépassant latéralement en direction de la couronne de volant (3), au-delà de l'espace de réception (19) ;
le dispositif de déclenchement électromécanique (5) présentant en outre au moins un capteur de force (8) disposé entre la saillie (6a, 6b) et le corps de volant (2) et par lequel le recouvrement de pot antichoc (6) prend appui sur le corps de volant (2), pour mesurer une valeur de force qui peut être attribuée à une force d'actionnement agissant sur la surface d'actionnement (15) du recouvrement de pot antichoc (6) ;
le dispositif de déclenchement électromécanique (5) comprenant en outre au moins une électronique d'évaluation (26) reliée au capteur de force (8) de manière électriquement conductrice afin d'établir au moyen de la valeur de force mesurée par ledit au moins un capteur de force (8) une valeur de force d'actionnement et pour déclencher le cas échéant l'émission acoustique du dispositif d'avertissement acoustique du véhicule, dans lequel en outre un élément de commande (7) électronique ou électromécanique, disposé au niveau du rayon (4), en particulier un élément de commande multifonctionnel, est prévu, et le recouvrement de pot antichoc (6) est disposé de manière adjacente à l'élément de commande (7), en y étant de préférence immobilisé,
**caractérisé en ce que** le capteur de force (8) est fixé sur une carte de circuits imprimés (25) de l'élément de commande (7).

2. Volant de véhicule (1) selon la revendication précédente, dans lequel la surface d'actionnement (15) s'étend à travers l'espace de réception (19), de préférence en réalisant une transition continue, dans la saillie (6a, 6b).

3. Volant de véhicule (1) selon l'une quelconque des revendications précédentes, dans lequel au moins deux saillies (6a, 6b) avec respectivement au moins un capteur de force (8) sont prévues.

4. Volant de véhicule (1) selon l'une quelconque des revendications précédentes, dans lequel l'électronique d'évaluation (26) présente une unité d'évaluation centrale pour déterminer une force d'actionnement à partir des valeurs de force de plusieurs, de préférence de tous les capteurs de force (8).

5. Volant de véhicule (1) selon l'une quelconque des revendications précédentes, dans lequel le capteur de force (8) est disposé respectivement entre le rayon (4) et la saillie (6a, 6b).

6. Volant de véhicule (1) selon l'une quelconque des revendications précédentes, dans lequel ledit au moins un capteur de force (8) est disposé en dehors d'un axe de direction (D) défini par le volant de véhicule (1), de plus grande préférence disposé en dehors de l'espace de réception (19) prévu pour recevoir le dispositif de déclenchement d'airbag (17, 18), de la plus grande préférence disposé radialement à côté du dispositif de déclenchement d'airbag (17, 18).

7. Volant de véhicule (1) selon l'une quelconque des revendications précédentes, dans lequel le capteur de force (8) mesure la valeur de force de manière optique, capacitive, inductive ou résistive.

8. Volant de véhicule (1) selon l'une quelconque des revendications précédentes, dans lequel des moyens (24) sont prévus pour polariser le capteur de force (8).

9. Volant de véhicule (1) selon l'une quelconque des revendications précédentes, dans lequel un dôme en matériau élastique est prévu comme élément de rappel (23) qui provoque le rappel élastique du recouvrement de pot antichoc (6).

10. Volant de véhicule (1) selon la revendication précédente, dans lequel le capteur de force (8) est disposé dans un volume creux (21) défini par le dôme (23).

11. Volant de véhicule (1) selon l'une quelconque des revendications précédentes, dans lequel plusieurs rayons (4) sont prévus, et le recouvrement de pot antichoc (6) présente plusieurs saillies (6a, 6b) s'étendant respectivement le long d'un des rayons de sorte que le recouvrement de pot antichoc (6) s'étend d'un rayon (4) à l'autre rayon (4) en chevauchant la zone de moyeu (10).

12. Volant de véhicule (1) selon l'une quelconque des revendications précédentes, dans lequel le recouvrement de pot antichoc (6) est immobilisé par un assemblage à encliquetage (9) qui produit en outre un effet de sollicitation sur la mobilité du recouvrement de pot antichoc (6), et/ou par une anse de positionnement (14) sur l'élément de commande (7).

13. Volant de véhicule (1) selon l'une quelconque des revendications précédentes, dans lequel l'élément de commande (7) présente une partie d'actionnement (7b) et/ou un obturateur dont la surface (7a) tournée vers le conducteur dans une position de repos de la partie d'actionnement (7b) et une position de repos du recouvrement de pot antichoc (6) passe en affleurement à la surface d'actionnement (15) du recouvrement de pot antichoc (6).

14. Utilisation du volant de véhicule (1) selon l'une quelconque des revendications précédentes dans un véhicule automobile.
